# EUROPEAN PATENT APPLICATION

(11) **EP 4 235 482 A1**
(43) Date of publication of application: **30.08.2023**
(21) Application number: 20935501.5
(22) Date of filing: 09.12.2020
(51) Int. Cl.: G06F 30/23

(54) **STATE PREVIEW METHOD AND SYSTEM FOR KEY EQUIPMENT OF NUCLEAR POWER PLANT, AND DEVICE AND STORAGE MEDIUM**

(30) Priority: 23.09.2020 CN 202011007520
(71) Applicant: China Nuclear Power Engineering Co., Ltd., Shenzhen, Guangdong 518124 (CN); China General Nuclear Power Corporation, Shenzhen, Guangdong 518026 (CN); CGN Power Co., Ltd., Shenzhen, Guangdong 518026 (CN)
(72) Inventor: GU, Hai Xia, Shenzhen, Guangdong 518124 (CN); LIU, Gao Jun, Shenzhen, Guangdong 518124 (CN)
(74) Representative: Greaves Brewster LLP
(86) International application number: PCT/CN2020/134722
(87) International publication number: WO 2021/227468

(57) **Abstract**

The present invention provides a state preview method and apparatus for key equipment of a nuclear power plant, and a computer device and a storage medium. The state preview method for key equipment of a nuclear power plant includes the steps of: acquiring historical operation data of each key equipment identifier (S201); constructing a state trend prediction model of the key equipment identifier on the basis of the historical operation data (S202); establishing a three-dimensional visualization model of the key equipment identifier by a finite element grid modeling method (S203); and carrying out state prediction calculation on key equipment by using the state trend prediction model according to a preset equipment mechanism model library, and mapping a calculation result into the three-dimensional visualization model to carry out a demonstration (S204). A change trend of key equipment and a time point at which a fault may occur can be visually and conveniently seen, thereby facilitating the improvement of the efficiency and timeliness of equipment maintenance.

## Description

### FIELD OF THE INVENTION

The present invention generally relates to the technical field of nuclear power plants and, more particularly, relates to a state preview method and system for key equipment of nuclear power plant, and device and storage medium.

### BACKGROUND OF THE INVENTION

Nuclear power plant has various kinds of equipments, complex structure and severe operating environment. Once the equipment malfunctions, not only will the equipments be damaged, but also system-level fault may occur, resulting in unit jumping, reactor jumping, causing huge economic losses. The failure of safety-level key equipment may even lead to nuclear safety accident. How to realize the safety detection and diagnosis of the key equipment of the unit in service is an urgent problem to be solved and studied.

In the process of the present invention, the inventor of the present invention found that the prior art at least has the following disadvantages: the state prediction and maintenance management of the conventional equipment mainly rely on personal subjective knowledge and experience. Although the three-dimensional visualization technology is relatively popular, the three-dimensional visualization technology is difficult to be applied in the state prediction visualization of nuclear power plant key equipment directly due to the variety and complexity of nuclear power plant equipments. How to acquire the state trend of key equipment in nuclear power plant quickly and intuitively has become an

### SUMMARY OF THE INVENTION

One object of the present invention is to provide a state preview method and apparatus for key equipment of nuclear power plant, and a computer device and a storage medium, so as to improve the visualization of state preview of key equipment in nuclear power plant.

According to one embodiment of the present invention, a state preview method for key equipment of nuclear power plant comprises the steps of:
acquiring historical operation data of each key equipment identifier;
constructing a state trend prediction model of the key equipment identifier on the basis of the historical operation data;
establishing a three-dimensional visualization model of the key equipment identifier by a finite element grid modeling method;
carrying out state prediction calculation on key equipment by using the state trend prediction model according to a preset equipment mechanism model library, and mapping a calculation result into the three-dimensional visualization model to carry out a demonstration.

According to one aspect of the present invention, the step of acquiring historical operation data of each key equipment identifier includes the steps of:
acquiring a preset key equipment identifier list, wherein the preset key equipment identifier list comprises a key equipment identifier;
acquiring a full life cycle corresponding to the key equipment identifier for each key equipment identifier, collecting data of the key equipment at regular intervals during the full life cycle, and obtaining an initial operation data of the key equipment identifier, wherein the initial operation data comprises the key equipment identifier, equipment parameter and equipment parameter value, the equipment parameter is used for characterizing a running state of the equipment corresponding to the key equipment identifier;
pre-processing the initial operation data to obtain a historical reference data, and storing the historical reference data in a historical operation database;
acquiring historical reference data corresponding to the key equipment identifier from the historical operation database as the historical operation data according to the key equipment identifier obtained.

According to one aspect of the present invention, acquiring historical reference data corresponding to the key equipment identifier from the historical operation database as the historical operation data according to the key equipment identifier obtained includes the steps of:
constructing a key equipment testing system;
receiving a key equipment state parameter table, wherein the key equipment state parameter table comprises at least one equipment parameter and at least one key equipment identifier;
taking the equipment parameter contained in the key equipment state parameter table as a target parameter, and taking the key equipment identifier contained in the key equipment state parameter table as target identifier;
detecting the target parameter in the target identifier via the key equipment testing system, obtaining the parameter value corresponding to the target parameter, and taking the target identifier, the target parameter and the parameter value corresponding to the target parameter as the initial operation data.

According to one aspect of the present invention, the step of carrying out state prediction calculation on key equipment by using the state trend prediction model according to a preset equipment mechanism model library and mapping a calculation result into the three-dimensional visualization model to carry out a demonstration includes the step of:
taking the received key equipment identifier as the target equipment identifier, and based on the target equipment identifier, constructing the mapping relationship of the state trend prediction model, the preset equipment mechanism model library, and the three-dimensional visualization model;
acquiring state of each part corresponding to the target equipment identifier based on the preset equipment mechanism model library;
inputting each part state corresponding to the target equipment identifier into the state trend prediction model for prediction calculation based on the mapping relationship, and obtaining the prediction result;
demonstrating the prediction results using the three-dimensional visualization model.

According to one aspect of the present invention, the step of carrying out state prediction calculation on key equipment by using the state trend prediction model according to a preset equipment mechanism model library, and mapping a calculation result into the three-dimensional visualization model to carry out a demonstration, the state preview method for key equipment of nuclear power plant further includes the steps of:
acquiring equipment characteristic data corresponding to each key equipment identifier;
constructing a mechanism model based on the equipment characteristic data;
correlating the mechanism model, the key equipment identifier and the equipment parameter corresponding to the key equipment identifier, to obtain a preset equipment mechanism model library.

According to one aspect of the present invention, after the step of carrying out state prediction calculation on key equipment by using the state trend prediction model according to a preset equipment mechanism model library, and mapping a calculation result into the three-dimensional visualization model to carry out a demonstration, the state preview method for key equipment of nuclear power plant further includes the steps of:
acquiring the key equipment identifier displayed in the demonstration having a failure in a preset time interval as the identifier of the equipment to be maintained, and obtaining the change information of the demonstration state of the equipment to be maintained as the reference trend information;
transmitting the identifier of the equipment to be maintained and the reference trend information to a monitoring terminal.

According to another embodiment of the present invention, a state preview apparatus for key equipment of nuclear power plant includes:
a historical data acquiring module for acquiring historical operation data of each key equipment identifier;
a trend prediction building module for constructing a state trend prediction model of the key equipment identifier on the basis of the historical operation data;
a visualization model building module for constructing a three-dimensional visualization model of the key equipment identifier by a finite element grid modeling method;
a three-dimensional visualization demonstrating module for carrying out state prediction calculation on key equipment by using the state trend prediction model according to a preset equipment mechanism model library, and mapping a calculation result into the three-dimensional visualization model to carry out a demonstration.

According to one aspect of the present invention, the historical data acquiring module includes:
a list acquiring unit for acquiring a preset key equipment identifier list, wherein the preset key equipment identifier list comprises a key equipment identifier;
a data collecting unit for acquiring a full life cycle corresponding to the key equipment identifier for each key equipment identification, collecting data of the key equipment at regular intervals in the full life cycle, and obtaining an initial operation data of the key equipment identifier, wherein the initial operation data comprises the key equipment identifier, equipment parameter and equipment parameter values, the equipment parameters are used for characterizing a running state of the equipment corresponding to the key equipment identifier;
a data processing unit for pre-processing the initial operation data to obtain a historical reference data, and storing the historical reference data in a historical operation database;
a data generating unit for acquiring historical reference data corresponding to the key equipment identifier from the historical operation database as the historical operation data according to the key equipment identifier obtained.

According to one aspect of the present invention, the data collecting unit includes:
a detection system constructing sub-unit for constructing the key equipment detecting system;
a parameter table receiving sub-unit for receiving a key equipment state parameter table, wherein the key equipment state parameter table includes at least one equipment parameter and at least one key equipment identifier;
a data confirming sub-unit for taking the equipment parameters contained in the key equipment state parameter table as target parameter, and taking the key equipment identifier contained in the key equipment state parameter table as target identifier;
a data detecting sub-unit for detecting a target parameter in the target identifier via the key equipment detecting system to obtain a parameter value corresponding to the target parameter, and taking the target identifier, the target parameter and the parameter value corresponding to the target parameter as an initial operation data.

According to one aspect of the present invention, the three-dimensional visualization demonstrating module includes:
a mapping relationship constructing unit for taking a received key equipment identifier as a target equipment identifier and, based on the target equipment identifier, constructing the mapping relationship of the state trend prediction model, the preset equipment mechanism model library, and the three-dimensional visualization model;
a state acquiring unit for obtaining each part state corresponding to the target equipment identifier based on the preset equipment mechanism model library;
a result prediction unit for inputting the each part state corresponding to the target equipment identifier into the state trend prediction model for prediction calculation based on the mapping relationship to obtain the prediction results;
a three-dimensional demonstrating unit for demonstrating the prediction results via using the three-dimensional visual model.

According to one aspect of the present invention, the state preview apparatus for key equipment of nuclear power plant also includes:
a characteristic data acquiring module for acquiring equipment characteristic data corresponding to each key equipment identifier;
a mechanism model constructing module for constructing a mechanism model based on the equipment characteristic data;
a mechanism model library generating module for correlating the mechanism model, the key equipment identifier and the equipment parameters corresponding to the key equipment identifier, to obtain the preset equipment mechanism model library.

According to one aspect of the present invention, the state preview apparatus for key equipment of nuclear power plant also includes:
an information acquiring module for acquiring the key equipment identifier displayed in the demonstration having a failure in a preset time interval as the identifier of the equipment to be maintained, and obtaining the change information of the demonstration state of the identifier of the equipment to be maintained as the reference trend information;
a maintenance reminding module for transmitting the identifier of the equipment to be maintained and the reference trend information to a monitoring terminal.

According to yet another embodiment of the present invention, a computer device includes a memory, a processor, and a computer program stored on the memory and capable of running on the processor, the processor executes the computer program to realize the state preview method for key equipment of nuclear power plant of the present invention.

According to another embodiment of the present invention, a computer-readable storage medium contains a computer program stored on the computer-readable storage medium, and the computer program is executed by the processor to realize the steps of the state preview method for key equipment of nuclear power plant of the present invention.

Compared with the prior art, the embodiments of the present invention have the following advantages:
Obtaining a historical operation data of each key equipment identifier, and based on the historical operation data, constructing a state trend prediction model of key equipment identifier, and establishing a three-dimensional visualization model of key equipment identifier via the finite element grid modeling method, using the state trend prediction model to predict the state of key equipment according to the preset equipment mechanism model library, mapping the calculation results to a three-dimensional visualization model to show the changing trend of key equipment and the possible time point of failure, which is helpful to improve the efficiency and timeliness of equipment maintenance.

### BRIEF DESCRIPTION OF THE DRAWINGS

The technical solution of the present invention will now be described more clearly in view of the drawings. The drawings described below only show some embodiments of the present invention. Obviously, based on the provided drawings, one ordinary skilled in the art can obtain other drawings without creative work.
Fig. 1 is an illustrative system architecture diagram to which the present invention can be applied;
Fig. 2 is a flow chart of a state preview method for key equipment of nuclear power plant according to one embodiment of the present invention;
Fig. 3 is a schematic diagram of a state preview apparatus for key equipment of nuclear power plant according to one embodiment of the present invention;
Fig. 4 is a schematic diagram of a computer device according to one embodiment of the present invention.

### DETAILED DESCRIPTION OF THE INVENTION

The technical solution of the embodiments of the present invention will be described clearly and completely in combination with the drawings. Obviously, the embodiments described are only a part of the embodiments of the present invention, not all embodiments. Therefore, the following detailed description of embodiments of the present invention provided in the attached drawings is not intended to limit the scope of the present invention, but merely represents selected embodiments of the present invention. Based on the embodiments of the present invention, other embodiments obtained by one ordinary skilled in the art without creative work also fall within the scope of the present invention.

Unless otherwise defined, all terms used herein shall have the same meaning as generally understood by one ordinary skilled in the art of the present application. The terms used in the specification of the present invention are intended only to describe specific embodiments and are not intended to limit the present invention. The terms "including" and "having" and any variation thereof in the specification and claims of the present invention are intended to cover non-exclusive inclusion. The terms "first", "second" and so on in the specification and claims of the present invention are used to distinguish different objects, not to describe a particular order.

The reference to "embodiments" in the present invention means that a particular feature, structure, or characteristic described in conjunction with an embodiment may be included in at least one embodiment of the present invention. It is explicitly and implicitly understood by one ordinary skilled in the art that the embodiments described in the present invention can be combined with other embodiments.

In order to make one ordinary skilled in the art better understand the technical solution of the present invention, the embodiments of the present invention will now be described clearly and completely in view of the drawings.

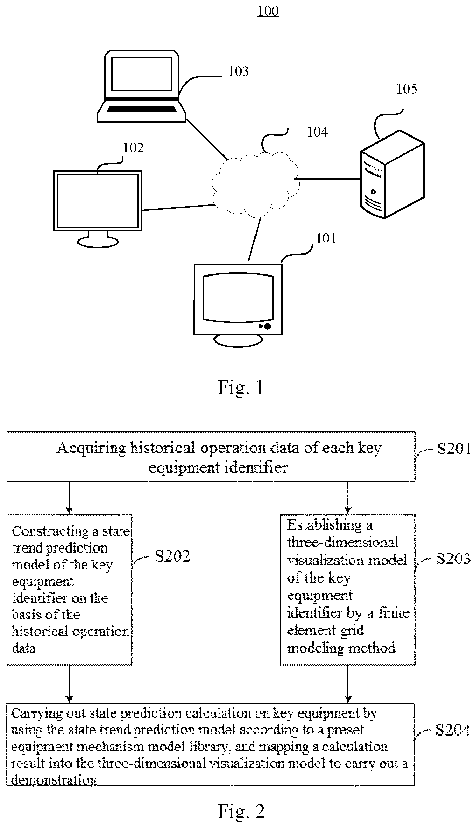

As shown in Fig. 1, the system architecture 100 can include terminal equipments 101, 102, 103, a network 104 and a server 105. The network 104 is a medium for providing a communication link between the terminal devices 101, 102, 103 and the server 105. The network 104 can include a variety of connection means, such as wired, wireless communication links or fiber optic cables.

Users can interact with the server 105 via the network 104 using terminal equipments 101, 102, 103 to receive or transmit messages.

Terminal equipments 101, 102, 103 may be a variety of electronic devices having a display screen and supporting web browsing, including but not limited to, smart phones, tablets, e-book readers, MP3 players (moving picture E interface showing perts Group Audio Layer III) , MP4 players (moving picture E interface showing perts Group Audio Layer IV) , laptops and desktop computers.

The server 105 can be a server that provides a variety of services, such as a back-end server that supports pages displayed on terminal equipments 101,102 and 103.

It should be noted that the state preview method for key equipment of a nuclear power plant provided in the present invention is performed by a server. Accordingly, the state preview apparatus for key equipment of a nuclear power plant is set in the server.

It should be understood that, the number of terminal equipments, networks, and servers in Fig. 1 is only illustrative. According to actual requirements, any number of terminal equipments, network and servers can be used. The terminal equipment 101, 102, 103 in the embodiment of the present application can correspond to the application system in actual production.

Referring further to Fig. 2, which shows a flow diagram of state preview method for key equipment of a nuclear power plant according to an embodiment of the present invention, the state preview method for key equipment of a nuclear power plant includes the steps of:
S201: acquiring historical operation data of each key equipment identifier.

Specifically, in the step of acquiring historical operation data of each key equipment identifier,
wherein the key equipment identifier is a string used to uniquely identify the key equipment, which can be one or more combinations of Chinese characters, letters and symbols.
wherein the historical operation data refers to various state data recorded in the running process of the equipment corresponding to the key equipment identifier.

It should be noted that the historical operation data includes time attributes. In other words, the historical operation data corresponding to a same key equipment identifier, at different time points may be the same or may be different.

S202: constructing a state trend prediction model of the key equipment identifier on the basis of the historical operation data.

Specifically, a state trend prediction model of the key equipment identifier is constructed on the basis of the historical operation data.

In the present embodiment, a state trend prediction model is obtained by training for internal correlations among a large number of historical operation data, the state trend prediction models include, but are not limited to, time series prediction model, regression prediction model, Kalman filter prediction model and back-propagation network prediction model. The selection of the prediction model can be based on the actual requirement.

It is easy to understand that, the state trend prediction model is used for predicting the state evolution trend of key equipment in a period in the future based on the state change of the key equipment identifier.

S203: establishing a three-dimensional visualization model of the key equipment identifier by a finite element grid modeling method.

Specifically, in view of the characteristics of various and complex structures of nuclear power plant equipment, the present embodiment adopts the finite element grid modeling method, and takes each key equipment identifier as a finite element. The three-dimensional visualization model of key equipment identifier is constructed by finite element grid modeling.
wherein finite element method (FEM) is a numerical technique for approximate solutions of partial differential equation boundary value problems. Finite element modeling is the process of constructing finite element models. The central task of modeling is discretization. However there is still a lot of work to be done around discretization, such as single structure form processing, geometric model building, unit type and quantity selection, unit characteristic definition, unit quality check, number sequence optimization and model boundary condition definition.

In the present embodiment, by finite element modeling of the equipment corresponding to each key equipment identifier, the corresponding units of each key equipment identifier are obtained, and the grid division of the units is carried out according to the actual needs, the finite element grids are obtained and put into the three-dimensional model by three-dimensional visualization, and the three-dimensional visualization model of the key equipment is obtained.
wherein the three-dimensional visualization model is a kind of model which can make the state change of the equipment corresponding to the key equipment identifier three-dimensional visualization. Three-dimensional visualization is representation of a data body, which can take advantage of large amounts of data to check the continuity of data, identify the authenticity of data, find and propose useful anomalies, provide a useful tool for analysis, understanding and duplication of data. Therefore, it is advantageous to realize the fast and visual demonstration of the various states of the key equipment.

S204: carrying out state prediction calculation on key equipment by using the state trend prediction model according to a preset equipment mechanism model library, and mapping a calculation result into the three-dimensional visualization model to carry out a demonstration.

Specifically, according to the preset equipment mechanism model library, the state trend prediction model is used to carry out the state prediction calculation of the key equipment, and the calculation results are mapped into the three-dimensional visualization model for demonstration. The concrete three-dimensional visualization demonstration process can refer to the description of the following embodiments, and to avoid repetition, will not be repeated here.
wherein the preset equipment mechanism model library is a pre-configured database which contains the key equipment mechanism model. Mechanism model also known as white box model, is an accurate mathematical model based on the internal mechanism of an object, a production process, or the transfer mechanism of a material flow The specific generation of the preset equipment mechanism model library will be described by following embodiments and will not be repeated here.

In the present embodiment, the historical operation data of each key equipment identifier is acquired, the state trend prediction model of the key equipment identifier is constructed on the basis of the historical operation data, the finite element grid modeling method is used to establish, the three-dimensional visualization model of key equipment identifier, the state trend prediction model is used to predict the state of key equipment according to the preset equipment mechanism model base, the results are mapped to a 3three-dimensional visualization model to show the changing trend of key equipment and the possible time point of failure, which is helpful to improve the efficiency and timeliness of equipment maintenance.

In some embodiments of the present invention, in step S201, the step of acquiring historical operation data of each key equipment identifier includes the steps of:
acquiring a preset key equipment identifier list, wherein the preset key equipment identifier list includes the key equipment identifier;
acquiring a full life cycle corresponding to the key equipment identifier for each key equipment identifier, collecting data of the key equipment at regular intervals during the full life cycle, and obtaining an initial operation data of the key equipment identifier, wherein the initial operation data includes the key equipment identifier, equipment parameter and equipment parameter value, the equipment parameter is used for characterizing a running state of the equipment corresponding to the key equipment identifier;
pre-processing the initial operation data to obtain a historical reference data, and storing the historical reference data in a historical operation database;
acquiring historical reference data corresponding to the key equipment identifier from the historical operation database as the historical operation data according to the key equipment identifier obtained.
wherein the initial operation data is the data collected by the key equipment detecting system.
wherein the full life cycle is all aspects of the life course of the equipment.
wherein the pre-processing of the data is the normalization and intensive data filtering of the initial operational data. Normalization refers to the unification of data formats and range. Intensive data filtering refers is to select the data that is too dense according to the preset data density, to reduce the amount of data that is too dense and improve the efficiency of subsequent model prediction.

It should be understood that a device parameter value refers to a specific quantitative value corresponding to the device parameter.

In the present embodiment, the historical reference data is obtained by collecting the data of the key equipment, and the acquired data is obtained according to the real running state, which is more real and objective, it is beneficial to improve the prediction accuracy of the state trend prediction model constructed bv the historical reference data.

In some embodiments of the present invention, collecting data of the key equipment at regular intervals during the full life cycle and obtaining an initial operation data of the key equipment identifier includes the steps of:
constructing a key equipment testing system;
receiving a key equipment state parameter table, wherein the key equipment state parameter table comprises at least one equipment parameter and at least one key equipment identifier;
taking the equipment parameter contained in the key equipment state parameter table as a target parameter, and taking the key equipment identifier contained in the key equipment state parameter table as target identifier;
detecting the target parameter in the target identifier via the key equipment testing system, obtaining the parameter value corresponding to the target parameter, and taking the target identifier, the target parameter and the parameter value corresponding to the target parameter as the initial operation data.

Specifically, via constructing a key equipment testing system, after receiving the state parameter table of key equipment, the key equipment identifier and equipment parameters in the table are detected, to obtain the initial operation data.
wherein the key equipment state parameter table refers to the parameter table used to identify the detection target, which includes at least one equipment parameter and at least one key equipment identifier, the key equipment identifier is the key equipment identifier which needs to carry out the data collection, and the equipment parameter is the data item which needs to carry out the collection.
wherein, the key equipment detecting system is a data collection system which is used to detect the equipment to be tested and the data items to be tested.

In the present embodiment, by constructing the key equipment detecting system, the data of the key equipment is collected regularly in the full life cycle, and the initial operation data of the key equipment identifier is obtained, so that the data obtained is real and objective. The use of this data in constructing state trend prediction model can improve the prediction accuracy of state trend prediction model.

In some embodiments of the present invention, in step S204, carrying out state prediction calculation on key equipment by using the state trend prediction model according to a preset equipment mechanism model library and mapping a calculation result into the three-dimensional visualization model to carry out a demonstration includes the step of:
taking the received key equipment identifier as the target equipment identifier, and based on the target equipment identifier, constructing the mapping relationship of the state trend prediction model, the preset equipment mechanism model library, and the three-dimensional visualization model;
acquiring state of each part corresponding to the target equipment identifier based on the preset equipment mechanism model library;
inputting each part state corresponding to the target equipment identifier into the state trend prediction model for prediction calculation based on the mapping relationship, and obtaining the prediction result;
demonstrating the prediction results using the three-dimensional visualization model.

Specifically, when at least one key equipment identifier is received, the received key equipment identifier is taken as the target equipment identifier, and obtaining the target equipment identifier from the state trend prediction model, the preset equipment mechanism model library and the three-dimensional visualization model. Via the target equipment identifier, the mapping relationship among the state trend prediction model, the preset equipment mechanism model base and the target equipment identifier obtained from three-dimensional visualization model is constructed, and then key equipment identifier is input into the preset equipment mechanism model library, the state of each part corresponding to the target equipment identifier is obtained, and the state of each part corresponding to the target equipment identifier is input into the state trend prediction model. The prediction calculation is carried out according to the change of the simulated state to obtain prediction results. Finally, the three-dimensional visualization model is used to demonstrate the prediction results.

In the present embodiment, the mapping relation of the state trend prediction model, the preset equipment mechanism model library and the three-dimensional visualization model is constructed by adopting the target equipment identifier, to realize the real-time demonstration of the prediction results of the state trend prediction model by using the three-dimensional visual model, which is beneficial to the visual display of the problems may appear in the pre-rotation process of the key equipment, to improve the efficiency of key equipment maintenance.

In some embodiments of the present invention, prior to step S204, the state preview method for key equipment of nuclear power plant also includes the steps of:
acquiring equipment characteristic data corresponding to each key equipment identifier;
constructing a mechanism model based on the equipment characteristic data;
correlating the mechanism model, the key equipment identifier and the equipment parameter corresponding to the key equipment identifier, to obtain a preset equipment mechanism model library.

Specifically, according to the key equipment identifier, the equipment characteristic data corresponding to the key equipment identifier are obtained from the manufacturers of these equipment through communications protocol, the mechanism model corresponding to the key equipment identifier is established through the equipment characteristic data, and the mechanism model, the key equipment identifier and the equipment parameters corresponding to the key equipment identifier are related, to obtain the preset device mechanism model library.
wherein the communications protocols include, but are not limited to, the internet control message protocol (ICMP), address resolution protocol (ARP) and file transfer protocol (FTP).

The mechanism model, also known as the white box model, is an accurate mathematical model based on the object, the internal mechanism of the production process, or the transfer mechanism of the material flow. It is a mathematical model based on mass balance equation, energy balance equation, momentum balance equation, phase balance equation, some physical property equation, chemical reaction law, and basic circuit law. The advantage of the mechanism model is that the parameters have very clear physical meaning. In the present embodiment, the mechanism model is obtained by simulating a large amount of equipment characteristic data, to obtain a mechanism model of the equipment characteristics data and the state.

Among them, the equipment characteristics data refers to the parameters related to the equipment performance state, such as manageability, security capability, support for transmitting power adjustable and support for MIMO functions.

In the present embodiment, a mechanism model is constructed from the equipment characteristic data, to obtain a preset equipment mechanism model library, which is beneficial for following trend prediction through the preset equipment mechanism model library, improve the efficiency and accuracy of predictions.

In some embodiments of the present invention, following step S204, the state preview method for key equipment of nuclear power plant also includes the steps of:
acquiring the key equipment identifier displayed in the demonstration having a failure in a preset time interval as the identifier of the equipment to be maintained, and obtaining the change information of the demonstration state of the equipment to be maintained as the reference trend information;
transmitting the identifier of the equipment to be maintained and the reference trend information to a monitoring terminal.

Specifically, in the process of three-dimensional visual demonstration, there is a time change. A time interval is pre-set. In the demonstration process, the pre-set time interval failure of the key equipment identifier is taken as the identifier of the equipment to be maintained. The change information of the demonstration state of the equipment to be maintained is obtained as the reference trend information. The identifier of the equipment to be maintained and the reference trend information is transmitted to the monitor, so that the administrator on the monitor side can find the corresponding equipment according to the identifier of the equipment to be maintained and determine the equipment parts to be maintained according to the reference trend information.
wherein the preset time interval can be set according to the actual requirements, there is no limit to the time interval.

It should be noted that the level of failure and the specific corresponding content of each level of failure in the present invention can be set according to the actual needs.

In the present embodiment, by monitoring the failure state during the demonstration process, the identifier of the equipment to be maintained and reference trend information obtained can be transmitted to the monitor, it is beneficial to advance the maintenance of the following possible failures and improve the timeliness and efficiency of the key equipment maintenance.

One ordinary skilled in the art can understand all or part of the process of realizing the above embodiment method can be completed by instructing the related hardware via computer program. The computer program may be stored in a computer-readable storage medium and, when executed, may include a flow of embodiments of the methods as described above. The storage media can be non-volatile storage media such as disk, CD, Read-Only Memory (ROM) , or Random Access Memory -RAM-RAM), or random access memory (RAM).

It should be understood that, although the steps in the flowchart shown in the diagram are shown in the order indicated by the arrows, the steps do not necessarily follow the order indicated by the arrows. Unless explicitly stated in the present invention, the steps are not strictly sequential and can be performed in other order. Furthermore, at least some of the steps in the flowchart can include multiple sub-steps or stages that are not necessarily performed at the same time, instead, they can be executed at different times, not necessarily sequentially, but alternately executed with other steps, sub-steps of other steps or at least part of a phase.

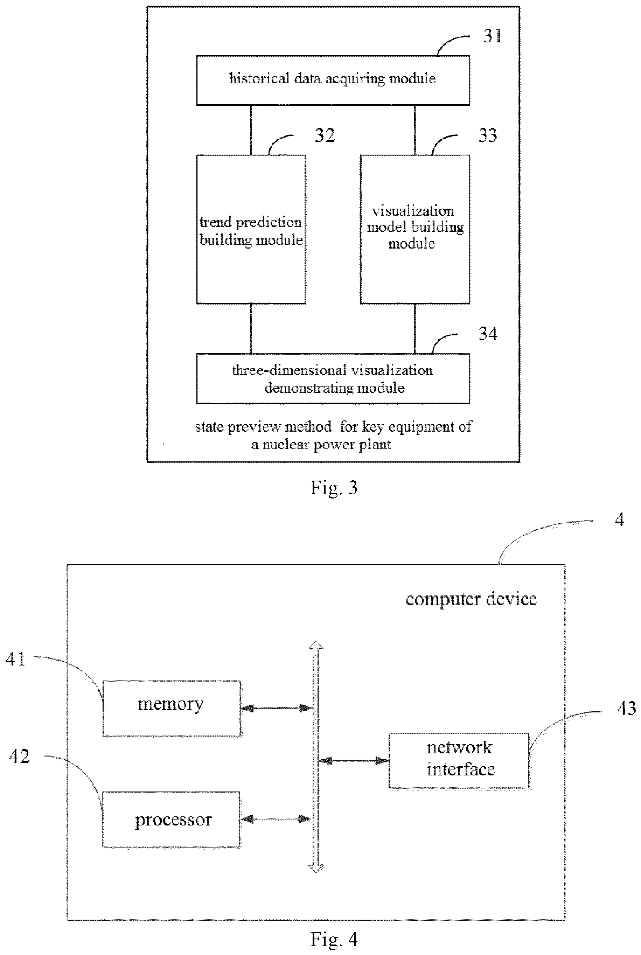

Referring further to Fig. 3, the present invention provides an embodiment of a state preview apparatus for key equipment of nuclear power plant for implementing the method shown in Fig. 2. The apparatus embodiment corresponds to the method embodiment shown in Fig. 2, and the apparatus can be specifically applied to various electronic devices.

As shown in Fig. 3, the state preview apparatus for key equipment of a nuclear power plant includes a historical data acquiring module 31, a trend prediction building module 32, a visualization model building module 33 and a three-dimensional visual demonstration module 34, wherein:
the historical data acquiring module 31 is used for acquiring historical operation data of each key equipment identifier;
the trend prediction building module 32 is used for constructing a state trend prediction model of the key equipment identifier on the basis of the historical operation data;
the visualization model building module 33 is used for build 3D visual model of key equipment identification by finite element mesh modeling method;
the three-dimensional visualization demonstrating module 34 for carrying out state prediction calculation on key equipment by using the state trend prediction model according to a preset equipment mechanism model library, and mapping a calculation result into the three-dimensional visualization model to carry out a demonstration.

Optionally, the historical data acquiring module 31 includes:
a list acquiring unit for obtaining a preset key equipment identifier list, wherein the preset key equipment identifier list includes a key equipment identifier list;
a data collecting unit for acquiring a full life cycle corresponding to the key equipment identifier for each key equipment identification, collecting data of the key equipment at regular intervals in the full life cycle, and obtaining an initial operation data of the key equipment identifier, wherein the initial operation data comprises the key equipment identifier, equipment parameter and equipment parameter values, the equipment parameters are used for characterizing a running state of the equipment corresponding to the key equipment identifier;
a data processing unit for pre-processing the initial operation data to obtain a historical reference data, and storing the historical reference data in a historical operation database;
a data generating unit for acquiring historical reference data corresponding to the key equipment identifier from the historical operation database as the historical operation data according to the key equipment identifier obtained.

Optionally, the data collecting unit includes:
a detection system constructing sub-unit for constructing the key equipment detecting system;
a parameter table receiving sub-unit for receiving a key equipment state parameter table, wherein the key equipment state parameter table includes at least one equipment parameter and at least one key equipment identifier;
a data confirming sub-unit for taking the equipment parameters contained in the key equipment state parameter table as target parameter, and taking the key equipment identifier contained in the key equipment state parameter table as target identifier;
a data detecting sub-unit for detecting a target parameter in the target identifier via the key equipment detecting system to obtain a parameter value corresponding to the target parameter, and taking the target identifier, the target parameter and the parameter value corresponding to the target parameter as an initial operation data.

Optionally, the three-dimensional visualization demonstrating module 34 includes:
a mapping relationship constructing unit for taking a received key equipment identifier as a target equipment identifier and, based on the target equipment identifier, constructing the mapping relationship of the state trend prediction model, the preset equipment mechanism model library, and the three-dimensional visualization model;
a state acquiring unit for obtaining each part state corresponding to the target equipment identifier based on the preset equipment mechanism model library;
a result prediction unit for inputting the each part state corresponding to the target equipment identifier into the state trend prediction model for prediction calculation based on the mapping relationship to obtain the prediction results;
a three-dimensional demonstrating unit for demonstrating the prediction results via using the three-dimensional visual model.

Alternatively, a three-dimensional demonstrating unit for demonstrating the prediction results via using the three-dimensional visual model;
a characteristic data acquiring module for acquiring equipment characteristic data corresponding to each key equipment identifier;
a mechanism model constructing module for constructing a mechanism model based on the equipment characteristic data;
a mechanism model library generating module for correlating the mechanism model, the key equipment identifier and the equipment parameters corresponding to the key equipment identifier, to obtain the preset equipment mechanism model library.

Alternatively, the state preview apparatus for key equipment of nuclear power plant also includes:
an information acquiring module for acquiring the key equipment identifier displayed in the demonstration having a failure in a preset time interval as the identifier of the equipment to be maintained, and obtaining the change information of the demonstration state of the identifier of the equipment to be maintained as the reference trend information;
a maintenance reminding module for transmitting the identifier of the equipment to be maintained and the reference trend information to a monitoring terminal.

The detailed manner in which each module performs the operation of the state preview method for key equipment of nuclear power plant in the above embodiment has been described in the embodiment of the method, and will not be detailed further here.

One embodiment of the present invention also provides a computer device. Referring to Fig. 4, which is the block diagram of the computer device of the present invention.

The computer device 4 includes a memory 41, a processor 42, and a network interface 43 in communication with each other through a system bus. It should be noted that only computer device with component-connected memory 41, processor 42, and network interface 43 are shown in Fig. 4, but it should be understood that not all of the components shown are required to be implemented, instead, implement more or fewer components. One ordinary skilled in the art can understand that the computer device is a kind of equipment that can carry out numerical calculation and/or information processing automatically according to pre-set or stored instructions. The hardware includes, but is not limited to, microprocessors, application specific integrated circuit (ASIC), field-programmable gate array (FPGA), digital signal processor (DSP), embedded devices, etc.

The computer device can be a desktop computer, a notebook, a PDA, a cloud server, and other computing device. The computer device can interact with the user through a keyboard, a mouse, a remote control, a touch plate, a voice-controlled device.

The memory 41 includes at least one type of readable storage medium. The readable storage medium includes a flash memory, a hard disk, a multimedia card, a card-type memory (e.g., SD or D interface display memory) , a random access memory (RAM) , a static random access memory (SRAM), a read-only memory (ROM), an electric-erased programmable read-only memory (EEPROM), a programmable read-only memory (PROM), a magnetic memory, a magnetic disk, an optical disk. In some embodiments of the present invention, the memory 41 may be an internal memory unit of the computer device 4, such as a hard disk or memory of the computer device 4. In other embodiment of the present invention, the memory 41 may also be an external storage device of the computer device 4, such as a plug-in hard disk, a smart media card (SMC), secure digital (SD) card, flash Card. Of course, the memory 41 may also include both an internal memory unit and an external memory device of the computer device 4. In the present embodiment, the memory 41 is commonly used to store the operating system and various application software installed in the computer device 4, such as program code for state preview methods of key equipment in a nuclear power plant. In addition, the memory 41 can be used for temporarily storing various types of data that have been output or will be output.

The processor 42 may in some embodiments be a central processing unit (CPU), controller, microcontroller, microprocessor, or other data processing chip. The processor 42 is typically used to control the overall operation of the computer device 4. In the present embodiment, the processor 42 is used for running program codes stored in the memory 41 or processing data, such as running program codes for state preview method and apparatus for key equipment of a nuclear power plant.

The network interface 43 includes wireless network interface or wired network interface. The network interface 43 is usually used to establish communication connection between the computer device 4 and other electronic devices.

The present invention also provides a computer-readable storage medium storing an interface display program, and the interface display program may be executed by at least one processor, to enable the at least one processor to perform steps of state preview method for key equipment of a nuclear power plant as described above.

Based on the description of the embodiments of the present invention, one ordinary skilled in the art can clearly understand that the above embodiment method can be realized by means of software and the necessary general hardware platform, as well as by hardware. However, in many cases, it is desirable to realize the method by means of software and the necessary general hardware platform. Based on the understanding, the technical solution of the present invention, in essence, or the portion that contributes to the prior art, may be represented in the form of a software product. The computer software product is stored in a storage medium (such as ROM/RAM, disk, CD-ROM), a number of instructions are included to enable a terminal device (which may be a cell phone, computer, server, air conditioner, or network device) to perform the method described in each embodiment of the present invention.

Obviously, the embodiments described above are only a part of the embodiments of the present application, not all embodiments of the present invention. The drawings only show some preferable embodiments of the present invention, but do not limit the scope of the present invention. The present invention may be implemented in many different forms and, conversely, the embodiments are provided with the aim of providing a more thorough understanding of the present invention. Although the present invention is described in detail in light of the preceding embodiments, one ordinary skilled in the art may modify the technical solutions described in the preceding specific implementation modalities, or some of the technical characteristics of the equivalent replacement. The same applies to any direct or indirect use of the equivalent structure of the specification and the attached drawings in other related technical fields.

## Claims

1. A state preview method for key equipment of nuclear power plant, **characterized in that** the state preview method for key equipment of nuclear power plant comprises the steps of:
S201: acquiring historical operation data of each key equipment identifier;
S202: constructing a state trend prediction model of the key equipment identifier on the basis of the historical operation data;
S203: establishing a three-dimensional visualization model of the key equipment identifier by a finite element grid modeling method;
S204: carrying out state prediction calculation on key equipment by using the state trend prediction model according to a preset equipment mechanism model library, and mapping a calculation result into the three-dimensional visualization model to carry out a demonstration.

2. The state preview method for key equipment of nuclear power plant according to claim 1, **characterized in that** the step of acquiring historical operation data of each key equipment identifier comprises the steps of:
acquiring a preset key equipment identifier list, wherein the preset key equipment identifier list comprises a key equipment identifier;
acquiring a full life cycle corresponding to the key equipment identifier for each key equipment identifier, collecting data of the key equipment at regular intervals during the full life cycle, and
obtaining an initial operation data of the key equipment identifier, wherein the initial operation data comprises the key equipment identifier, equipment parameter and equipment parameter value, the equipment parameter is used for characterizing a running state of the equipment corresponding to the key equipment identifier;
pre-processing the initial operation data to obtain a historical reference data, and storing the historical reference data in a historical operation database;
acquiring historical reference data corresponding to the key equipment identifier from the historical operation database as the historical operation data according to the key equipment identifier obtained.

3. The state preview method for key equipment of nuclear power plant according to claim 2, **characterized in that** the step of collecting data of the key equipment at regular intervals during the full life cycle and obtaining an initial operation data of the key equipment identifier comprises the steps of:
constructing a key equipment testing system;
receiving a key equipment state parameter table, wherein the key equipment state parameter table comprises at least one equipment parameter and at least one key equipment identifier;
taking the equipment parameter contained in the key equipment state parameter table as a target parameter, and taking the key equipment identifier contained in the key equipment state parameter table as target identifier;
detecting the target parameter in the target identifier via the key equipment testing system, obtaining the parameter value corresponding to the target parameter, and taking the target identifier, the target parameter and the parameter value corresponding to the target parameter as the initial operation data.

4. The state preview method for key equipment of a nuclear power plant according to claim 2 or 3, **characterized in that** the step of carrying out state prediction calculation on key equipment by using the state trend prediction model according to a preset equipment mechanism model library, and mapping a calculation result into the three-dimensional visualization model to carry out a demonstration comprises the step of:
taking the received key equipment identifier as the target equipment identifier, and based on the target equipment identifier, constructing the mapping relationship of the state trend prediction model, the preset equipment mechanism model library, and the three-dimensional visualization model;
acquiring state of each part corresponding to the target equipment identifier based on the preset equipment mechanism model library;
inputting each part state corresponding to the target equipment identifier into the state trend prediction model for prediction calculation based on the mapping relationship and obtaining the prediction result;
demonstrating the prediction results using the three-dimensional visualization model.

5. The state preview method for key equipment of nuclear power plant according to claim 2, **characterized in that** before the step of carrying out state prediction calculation on key equipment by using the state trend prediction model according to a preset equipment mechanism model library, and mapping a calculation result into the three-dimensional visualization model to carry out a demonstration, the state preview method for key equipment of nuclear power plant further comprises the steps of:
acquiring equipment characteristic data corresponding to each key equipment identifier;
constructing a mechanism model based on the equipment characteristic data;
correlating the mechanism model, the key equipment identifier and the equipment parameter corresponding to the key equipment identifier, to obtain a preset equipment mechanism model library.

6. The state preview method for key equipment of nuclear power plant according to claim 1, **characterized in that**, after the step of carrying out state prediction calculation on key equipment by using the state trend prediction model according to a preset equipment mechanism model library, and mapping a calculation result into the three-dimensional visualization model to carry out a demonstration, the state preview method for key equipment of nuclear power plant further comprises the steps of:
acquiring the key equipment identifier displayed in the demonstration having a failure in a preset time interval as the identifier of the equipment to be maintained, and obtaining the change information of the demonstration state of the equipment to be maintained as the reference trend information;
transmitting the identifier of the equipment to be maintained and the reference trend information to a monitoring terminal.

7. A state preview apparatus for key equipment of nuclear power plant, **characterized in that** the state preview apparatus for key equipment of nuclear power plant comprises:
a historical data acquiring module (31) for acquiring historical operation data of each key equipment identifier;
a trend prediction building module (32) for constructing a state trend prediction model of the key equipment identifier on the basis of the historical operation data;
a visualization model building module (33) for constructing a three-dimensional visualization model of the key equipment identifier by a finite element grid modeling method;
a three-dimensional visualization demonstrating module (34) for carrying out state prediction calculation on key equipment by using the state trend prediction model according to a preset equipment mechanism model library, and mapping a calculation result into the three-dimensional visualization model to carry out a demonstration.

8. The state preview apparatus for key equipment of nuclear power plant according to claim 7, **characterized in that** the historical data acquiring module (31) comprises:
a list acquiring unit for acquiring a preset key equipment identifier list, wherein the preset key equipment identifier list comprises a key equipment identifier;
a data collecting unit for acquiring a full life cycle corresponding to the key equipment identifier for each key equipment identification, collecting data of the key equipment at regular intervals in the full life cycle, and obtaining an initial operation data of the key equipment identifier, wherein the initial operation data comprises the key equipment identifier, equipment parameter and equipment parameter values, the equipment parameters are used for characterizing a running state of the equipment corresponding to the key equipment identifier;
a data processing unit for pre-processing the initial operation data to obtain a historical reference data,
and storing the historical reference data in a historical operation database;
a data generating unit for acquiring historical reference data corresponding to the key equipment identifier from the historical operation database as the historical operation data according to the key equipment identifier obtained.

9. A computer device, **characterized in that** the computer device comprises a memory, a processor, and a computer program stored on the memory and capable of running on the processor, the processor executes the computer program to realize the state preview method for key equipment of nuclear power plant of anyone of claims 1 to 6.

10. A computer-readable storage medium, **characterized in that** a computer program is stored on the computer-readable storage medium, and the computer program is executed by the processor to realize the steps of the state preview method for key equipment of nuclear power plant of anyone of claims 1 to 6.
